(19) Europäisches Patentamt
European Patent Office
Office européen des brevets

(11) **EP 2 826 147 B1**

(12) **EUROPÄISCHE PATENTSCHRIFT**

(45) Veröffentlichungstag und Bekanntmachung des Hinweises auf die Patenterteilung:
**12.04.2017 Patentblatt 2017/15**

(51) Int Cl.:
*H03M 1/08* (2006.01)   *H03M 1/50* (2006.01)
*G01R 19/00* (2006.01)

(21) Anmeldenummer: **13705721.2**

(22) Anmeldetag: **15.02.2013**

(86) Internationale Anmeldenummer:
**PCT/EP2013/000443**

(87) Internationale Veröffentlichungsnummer:
**WO 2013/135338 (19.09.2013 Gazette 2013/38)**

(54) **INTEGRIERENDER A/D-WANDLER**

INTEGRATING A/D CONVERTER

CONVERTISSEUR A/N À INTÉGRATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.03.2012   DE 102012102081**

(43) Veröffentlichungstag der Anmeldung:
**21.01.2015   Patentblatt 2015/04**

(73) Patentinhaber: **Sartorius Lab Instruments GmbH & Co. KG**
**37079 Göttingen (DE)**

(72) Erfinder:
• **FELDOTTE, Heinrich**
  **37079 Göttingen (DE)**
• **HOLST, Heyko**
  **37085 Göttingen (DE)**

(56) Entgegenhaltungen:
**WO-A2-02/103914     US-A- 4 951 053**

**Beschreibung**

Gebiet der Erfindung

Die Erfindung bezieht sich auf einen integrierenden A/D-Wandler, umfassend

- einen Messspannungseingang zum Anlegen einer zu digitalisierenden, analogen Messspannung, der über einen Messwiderstand mit dem invertierenden Eingang eines Integrators verbunden ist,
- einen ersten Referenzspannungseingang zum Anlegen einer ersten Referenzspannung und einen zweiten Referenzspannungseingang zum Anlegen einer zweiten Referenzspannung, wobei der erste und der zweite Referenzspannungseingang mittels eines ersten Referenzspannungsschalters alternativ zueinander über einen ersten Referenzwiderstand mit dem invertierenden Eingang des Integrators verbindbar sind,
- einen dem Integrator nachgeschalteten Komparator zum Vergleichen einer an seinem Komparator-Testspannungseingang anliegenden Testspannung mit einer an seinem Komparator-Referenzspannungseingang anliegenden Komparator-Referenzspannung, wobei der Komparator-Testspannungseingang mit dem Ausgang des Integrators verbunden ist, und
- eine Steuereinrichtung, die eingerichtet ist, den ersten Referenzspannungsschalter getaktet zu betätigen und Zeitintervalle zwischen einzelnen Schaltvorgängen zu messen.

Stand der Technik

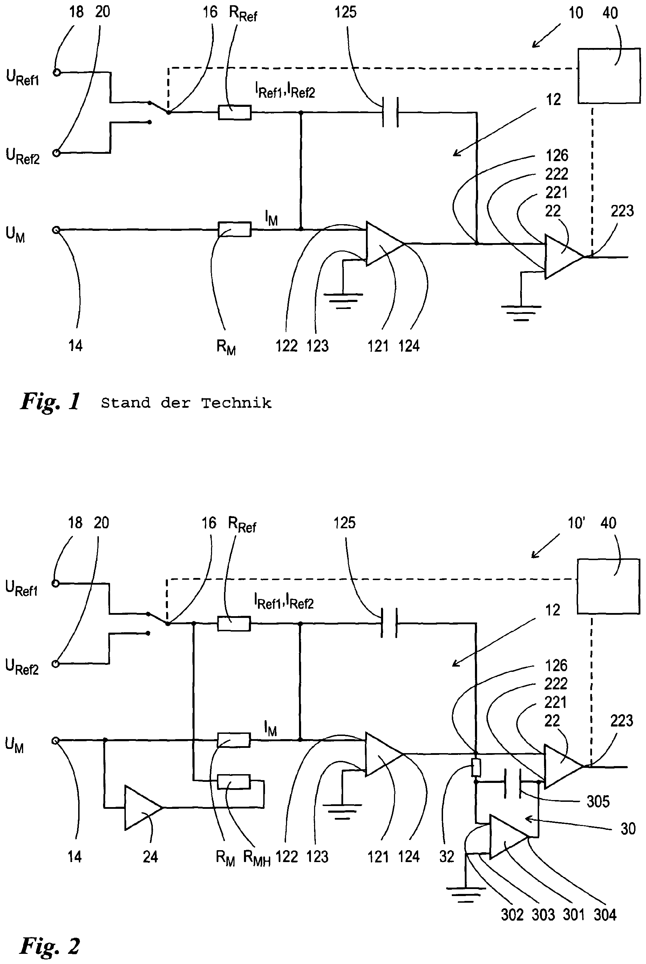

Derartige Analog/Digital-Wandler, kurz A/D-Wandler, die dem Wandeln einer analogen Messspannung in ein digitales Signal dienen, sind vielfach bekannt. Ein Prinzipschaltbild eines solchen A/D-Wandlers 10 ist in Figur 1 dargestellt. Das "Kernstück" des A/D-Wandlers 10 ist der Integrator 12, der einen Operationsverstärker mit einem invertierenden Eingang 122, einem nicht-invertierenden Eingang 123 und einem Ausgang 124 sowie einen Kondensator 125 umfasst, der zwischen dem invertierenden Eingang 122 und dem Ausgang 124 des Operationsverstärkers 122 geschaltet ist. Der nichtinvertierende Eingang 123 des Operationsverstärkers 121 ist gegen eine Referenzspannung, insbesondere gegen Masse geschaltet. Der invertierende Eingang 122 ist über den Messwiderstand $R_M$ mit dem Messspannungseingang 14 verbunden, an den bei Betrieb die Messspannung $U_M$ angelegt wird. Außerdem ist der invertierende Eingang 122 über einen Referenzwiderstand $R_{ref}$ mit dem Referenzspannungsschalter 16 verbunden, der je nach Schaltstellung alternativ entweder den ersten Referenzspannungseingang 18 oder den zweiten Referenzspannungseingang 20 elektrisch ankoppelt. An den Referenzspannungseingängen 18, 20 liegt jeweils eine Referenzspannung $U_{ref1}$ bzw. $U_{ref2}$ an, die typischerweise zueinander umgekehrte Polarität haben und den gleichen oder unterschiedliche Spannungswerte aufweisen können. Insbesondere bei monopolaren Messspannungen $U_M$ kann eine der Referenzspannungen auch Null sein, d.h. der entsprechende Referenzspannungseingang ist offen oder gegen Masse geschaltet. Der Integratorausgang 126, ist mit dem Testspannungseingang 221 eines Komparators 22 verbunden, dessen Referenzspannungseingang 222 gegen eine Komparator-Referenzspannung geschaltet ist, die z.B. Masse sein kann. Der Komparator 22 gibt an seinem Ausgang 223 jeweils ein Signal oder eine Signaländerung aus, wenn die am Testspannungseingang 221 anliegende Testspannung der am Referenzspannungseingang 222 anliegenden Referenzspannung entspricht. Das Komparator-Ausgangssignal ist über eine Steuereinrichtung 40 als Schaltsignal zum Referenzspannungsschalter 16 rückgekoppelt.

Ein derartiger A/D-Wandler arbeitet wie folgt: In einer ersten Phase eines Messtaktes T ist der Referenzspannungsschalter 16 so geschaltet, dass der erste Referenzspannungseingang 18 angeschlossen ist. Während dieser Phase integriert der Integrator die Summe aus dem Messstrom IM, der sich aus dem Spannungsabfall der Messspannung UM über dem Messwiderstand $R_M$ ergibt, und dem Referenzstrom $I_{ref1}$, der sich aus dem Spannungsabfall der ersten Referenzspannung $U_{ref1}$ über dem Referenzwiderstand $R_{ref}$ ergibt, auf. Nach einer von der Steuereinrichtung 40 vorgegebenen Zeit t1 schaltet der Referenzspannungsschalter 16 um, sodass der erste Referenzspannungseingang 18 abgekoppelt und der zweite Referenzspannungseingang 20 angekoppelt wird. Der Integrator integriert nun die Summe aus Messstrom $I_M$ und dem Referenzstrom $I_{ref2}$. der sich durch den Spannungsabfall der zweiten Referenzspannung $U_{ref2}$ über dem Referenzwiderstand $R_{ref}$ ergibt, ab. Bei diesem Beispiel sind die Polaritäten von Messspannung UM und erster Referenzspannung $U_{ref1}$ entgegengesetzt und die Polaritäten von Messspannung UM und zweiter Referenzspannung $U_{ref2}$ gleich. Die auf- bzw. abintegrierte Spannung liegt jeweils am Integratorausgang 126 und somit am Testspannungseingang 221 des Komparators 22 an. Diese zweite oder Abintegrationsphase hat eine Dauer $\tau$. Sobald die Integratorspannung vollständig abintegriert ist, ergeht ein Komparator-Signal, welches von der Steuereinrichtung 40 genutzt wird, um den Referenzspannungsschalter 16 erneut umzuschalten und einen neuen Messtakt zu beginnen. Außerdem kann die Steuereinrichtung 40, die während des vergangenen Messtaktes T die Zeitdauern der beiden Messtaktphasen t1 = T-$\tau$ und $\tau$ gemessen und insbesondere das Verhältnis der Dauer der zweiten Messphase $\tau$ zur Gesamtdauer T des vergangenen Messtaktes, d.h. den Tastgrad $\delta = \tau/T$ berechnet hat, einen entsprechenden Zahlenwert ausgeben, der ein Maß für die während des Messtaktes anliegende Messspannung UM ist. Aus der WO 02/103914 A2 und der US 4 951 053 A sind standesgemäße integrierende A/D-Wandler bekannt.

Aus der DE 28 21 146 B2 ist ein integrierender A/D-Wandler bekannt, bei dem die Referenzspannung als von der Eingangsspannung teilweise überlagerte Spannung unter Verwendung eines Umkehrverstärkers ausgebildet wird.

Aus der US 4,270,119 ist ein integrierender A/D-Wandler bekannt, bei dem im Referenzzweig eine invertierte Referenzspannung überlagert wird.

Aus der GB 2 120 481 A ist ein integrierender A/D-Wandler bekannt, bei dem eine Sensorkalibrierung bzw. -linearisierung durch Beschaltung mit einem Widerstand zwischen Eingangsspannung und Referenzspannung vorgenommen wird.

Nachteilig bei den bekannten A/D-Wandlern ist die nicht-lineare Abhängigkeit der Verlustleitung vom Tastgrad $\delta$ und somit von der Höhe der Messspannung, d.h. vom Messwert selbst. Insbesondere lässt sich die Verlustleistung als Funktion des Tastgrades $\delta$ berechnen als

$$
\begin{aligned}
P = \; & \delta^2 \, R_M \left( I_{ref1}^2 + I_{ref2}^2 + 2 I_{ref1} I_{ref2} \right) \\
& - \delta \left[ R_M \left( I_{ref2}^2 + 2 I_{ref1} I_{ref2} \right) + R_{ref} \left( I_{ref2}^2 - I_{ref1}^2 \right) \right] \\
& + R_M \left( I_{ref2}^2 + 2 I_{ref1} I_{ref2} \right) + R_{ref} I_{ref2}^2
\end{aligned}
$$

Eine derartige nicht-lineare Abhängigkeit des A/D-Wandlers von der zu digitalisierenden Größe ist für viele Präzisionsmessungen nicht tragbar. Als Beispiel seien nach dem Prinzip der Kraftmesskompensation arbeitende Präzisionswägeeinrichtungen genannt, bei denen die am Messspannungseingang 14 anliegende Messspannung $U_M$ proportional zu der Kraft ist, die auf einen Wägeaufnehmer wirkt. Messwertabhängige Verlustleistungen im A/D-Wandler führen zu einer messwertabhängigen Erwärmung, die ihrerseits Einfluss auf temperatursensitive Elemente der Elektronik hat, sodass systematische, messwertabhängige Messfehler entstehen können.

Aufgabenstellung

Es ist die Aufgabe der vorliegenden Erfindung, einen gattungsgemäßen A/D-Wandler derart weiterzubilden, dass die Abhängigkeit seiner Verlustleistung vom Messwert deutlich reduziert wird.

Darlegung der Erfindung

Diese Aufgabe wird in Verbindung mit den Merkmalen des Oberbegriffs von Anspruch 1 dadurch gelöst, dass zwischen dem Messspannungseingang und dem Ausgang des Referenzspannungsschalters ein die Messspannung invertierender Inverter und ein erster Heizwiderstand $R_{MH}$, der thermisch mit dem Messwiderstand $R_M$ gekoppelt ist, hintereinander geschaltet sind.

Kerngedanke der vorliegenden Erfindung ist es, einen zusätzlichen Heizwiderstand $R_{MH}$ vorzusehen, der als Verlustleistung genau die Differenz der vom Messwiderstand $R_M$ aufgenommenen Verlustleistung zu einer konstanten Gesamtverlustleistung aufnimmt. Mit anderen Worten ist die Summe aus den Verlustleistungen, die vom Heizwiderstand $R_{MH}$ und vom Messwiderstand $R_M$ gemeinsam aufgenommen werden, stets gleich und unabhängig vom Messwert. Folglich bleibt der Wärmeeintrag messwertunabhängig konstant. Dies gilt zumindest nach einer Einschwingphase, in der das thermische Gleichgewicht erreicht wird. Der Widerstandswert des Referenzwiderstandes $R_{ref}$ ist bevorzugt gleich dem Widerstandswert des Messwiderstandes $R_M$.

Die Funktionsfähigkeit der Erfindung ist ohne weiteres gegeben, wenn die Beträge der Referenzspannungen $U_{ref1}$ und $U_{ref2}$ gleich und ihre Polaritäten einander entgegengesetzt sind. Dann nämlich fließt unabhängig vom Schaltzustand des Referenzspannungsschalters jeweils der gleiche Referenzstrom durch den Referenzwiderstand $R_{ref}$. In Fällen, in denen unterschiedliche Referenzspannungsbeträge angelegt werden sollen, bedarf es zusätzlicher Maßnahmen, um die Gesamtverlustleistung des A/D-Wandlers konstant zu halten. Bei einer Weiterbildung der Erfindung ist daher vorgesehen, dass ein dem ersten Referenzspannungsschalter entgegengesetzt getakteter, zweiter Referenzspannungsschalter vorhanden ist, mittels dessen der erste und der zweite Referenzspannungseingang alternativ zueinander über einen zweiten Heizwiderstand $R_{refH}$, der thermisch mit dem Referenzwiderstand $R_{ref}$ und dem Messwiderstand $R_M$ gekoppelt ist, mit Masse verbindbar sind. Dies bedeutet, dass jeweils diejenige Referenzspannung, die nicht am Referenzwiderstand $R_{ref}$ anliegt, über den zweiten Heizwiderstand $R_{refH}$ abfällt und eine entsprechende zusätzliche Verlustleistung erzeugt. Um allerdings sicherzustellen, dass die gesamte, an Messwiderstand $R_M$, erstem Heizwiderstand $R_{MH}$, Referenzwiderstand $R_{ref}$ und zweitem Heizwiderstand $R_{refH}$ aufgenommene Verlustleistung messwertunabhängig konstant ist, ist, wie bei einer bevorzugten Ausführungsform vorgesehen, den Widerstandswert des zweiten Heizwiderstandes $R_{refH}$ genau halb so groß wie den Widerstandswert des ersten Heizwidertandes $R_{MH}$ zu dimensionieren. Bei einer solchen Ausführungsform ist die Gesamtverlustleistung insgesamt zwar höher als die Verlustleistung bei einem A/D-Wandler der zuvor beschriebenen Bauweise; im Gegensatz zu diesem erlaubt er jedoch die Verwendung betragsmäßig unterschiedlicher Referenzspannungen.

Das grundsätzliche Betriebsverfahren für einen erfindungsgemäßen A/D-Wandler entspricht uneingeschränkt dem oben detailliert erläuterten Betriebsverfahren für A/D-Wandler nach dem Stand der Technik.

Weitere Merkmale und Vorteile der Erfindung ergeben sich aus der nachfolgenden speziellen Beschreibung und den Zeichnungen.

Kurzbeschreibung der Zeichnungen

Es zeigen:

Figur 1: Ersatzschaltbild eines A/D-Wandlers gem. Stand der Technik,

Figur 2: Ersatzschaltbild einer ersten Ausführungsform eines erfindungsgemäße A/D-Wandlers,

Figur 3: Ersatzschaltbild einer zweiten Ausführungsform eines erfindungsgemäßen A/D-Wandlers,

Figur 4: ein schematisches Diagramm des Spannungsverlaufs am Integratorausgang der A/D-Wandler gem. Figuren 2 und 3.

Beschreibung bevorzugter Ausführungsformen

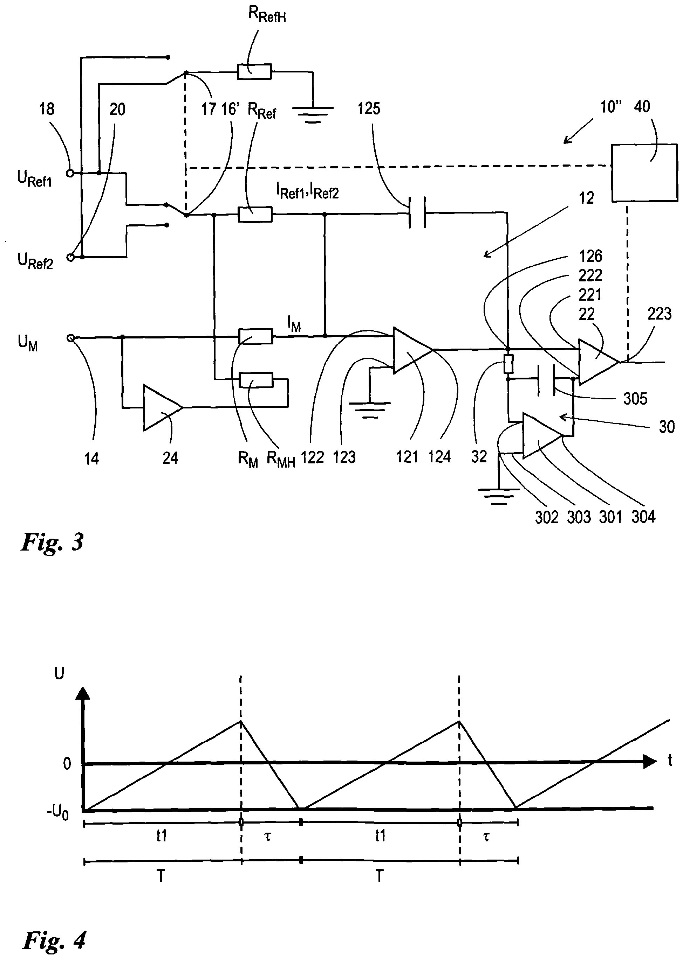

Figur 1 zeigt einen A/D-Wandler gem. Stand der Technik und wurde bereits eingangs detailliert beschrieben. Die Figuren 2 und 3 zeigen vorteilhafte Ausführungsformen eines erfindungsgemäßen A/D-Wandlers, wobei gleiche Bezugszeichen in allen Figuren auf gleiche oder analoge Bauteile hinweisen. Figur 4 zeigt ein Diagramm des zeitlichen Verlaufs der Integratorausgangsspannung, wie er bei jedem der A/D-Wandler der Figuren 1 bis 3, d.h. sowohl bei einem A/D-Wandler gem. Stand der Technik als auch bei einem erfindungsgemäßen A/D-Wandler auftritt. Nachfolgend sollen die erfindungsgemäßen A/D-Wandler im Wesentlichen durch Erläuterung ihrer Unterschiede zu dem A/D-Wandler gem. Figur 1 beschrieben werden.

Der A/D-Wandler 10' der Figur 2 unterscheidet sich in zwei Aspekten von dem A/D-Wandler 10 der Figur 1. Erfindungsgemäß ist sein Messspannungseingang 14 über einen Inverter 24, d.h. über einen Spannungsverstärker mit Verstärkungsfaktor "-1", und den Heizwiderstand $R_{MH}$ mit dem Ausgang des Referenzspannungsschalters 16 verbunden. Der Widerstandswert des Heizwiderstands $R_{MH}$ ist gleich dem Widerstandswert des Messwiderstandes $R_M$. Ebenso ist der Widerstandswert des Referenzwiderstandes $R_{ref}$ gleich dem Widerstandswert des Messwiderstandes $R_M$. Die resultierende Verlustleistungskonstanz des A/D-Wandlers gem. Figur 2 lässt sich mathematisch wie folgt zeigen:

Über einen Messtakt T gemittelt gilt

$$I_M T + I_{ref1}\tau + I_{ref2}\left(T - \tau\right) = 0$$

Die an Mess-, Heiz- und Referenzwiderstand $R_M$, $R_{MH}$ und $R_{ref}$ anfallende Gesamtverlustleistung lässt sich schreiben als

$$P = \frac{U_M^2}{R_M} + \frac{U_{ref2}^2}{R_{ref}}\left(1-\delta\right) + \frac{U_{ref1}^2}{R_{ref}}\delta$$
$$+ \frac{\left(-U_M - U_{ref2}\right)^2}{R_{MH}}\left(1-\delta\right) + \frac{\left(-U_M - U_{ref1}\right)^2}{R_{MH}}\delta$$

Mit

$$R_M = R_{ref} \quad ; \quad R_{MH} = R_M \quad ; \quad \left| U_{ref1} \right| = \left| U_{ref2} \right|$$

und Einsetzen der obigen Gleichung für den Messstrom IM und Umformung mittel Ohmschen Gesetzes fallen alle Abhängigkeiten von δ heraus, sodass die Verlustleistung tastgradunabhängig und damit messwertunabhängig ist.

Der zweite Aspekt, in dem sich der A/D-Wandler 10' der Figur 2 von dem A/D-Wandler 10 der Figur 1 unterscheidet, ist die Ausgestaltung der am Referenzspannungseingang 222 des Komparators 22 angelegten Komparator-Referenzspannung. Während beim A/D-Wandler 10 von Figur 1 hier schlicht Masse anliegt, ist beim A/D-Wandler 10' von Figur 2 der Ausgang eines zusätzlichen Integrators 30 mit dem Komparator-Referenzspannungseingang 222 verbunden. Der zusätzliche Integrator 30 umfasst einen Operationsverstärker 301 mit einem invertierenden Eingang 302, einem nicht-invertierenden Eingang 303 und einem Ausgang 304. Während der nichtinvertierende Eingang 303 gegen Masse geschaltet ist, ist der invertierende Eingang 302 über einen Kondensator 305 mit dem Ausgang 304 verbunden. Der Eingang des Integrators 30 liegt über einen Eingangswiderstand 32 am Ausgang 126 des Integrators 12 an. Die Wirkungsweise des zusätzlichen Integrators 30 liegt darin, dass er das Ausgangssignal des Integrators 12 mittelt und invertiert und dieses gemittelte Signal als Komparator-Referenzspannung dem Komparator 22 zur Verfügung stellt. Mit anderen Worten wird also im Komparator 22 das Integratorausgangssignal des Integrators 12 nicht mehr mit Masse verglichen, sondern mit seinem eigenen Mittelwert. Dadurch liegt am Kondensator 125 des Integrators 12 ein Spannungssignal ohne Gleichanteil an. Hierdurch werden gleichspannungsbedingte Störungen des Kondensators 125, wie beispielsweise Fehlströme und dielektrische Absorption vermieden oder zumindest reduziert. Hierdurch wird es möglich, ohne Einbußen in der Funktionalität im Integrator 12 qualitativ weniger hochwertige Kondensatorentypen als Kondensator 125 zu verwenden, was sich in einer deutlichen Kostenreduktion der Schaltung bzw. einer Verbesserung der Messqualität niederschlägt. Nachteile in Bezug auf die erfindungsgemäße Verlustleistungskonstanz des A/D-Wandlers ergeben sich nicht, da die von dem Eingangswiderstand 32 des zusätzlichen Integrators 30 aufgenommene Verlustleistung tastgradunabhängig ist.

Wie erläutert muss zur Erzielung der erfindungsgemäßen Verlustleistungskonstanz bei einem A/D-Wandler gem. Figur 2 eine betragsmäßige Gleichheit der Referenzspannungen $U_{ref1}$ und $U_{ref2}$ bestehen. Ist diese Einschränkung aus irgendwelchen Gründen nicht erwünscht und soll dennoch die erfindungsgemäße Verlustleistungskonstanz erhalten bleiben, ist eine Erweiterung der Schaltung wie in Figur 3 gezeigt erforderlich. Bei dem in Figur 3 dargestellten A/D-Wandler 10" ist parallel zu dem ersten Referenzspannungsschalter 16' ein zweiter Referenzspannungsschalter 17 vorgesehen, der gegenläufig zum ersten Referenzspannungsschalter 16' geschaltet ist, d.h. jeweils den anderen Referenzspannungseingang mit dem jeweiligen Schalterausgang verbindet. Die jeweils nicht über den Referenzwiderstand $R_{ref}$ abfallende Referenzspannung fällt somit über den zweiten Heizwiderstand $R_{refH}$ ab. Die Funktionsweise dieser Ausführungsform lässt sich mathematisch wie folgt beschreiben:

Über einen Messtakt lässt sich auch hier der Messstrom IM schreiben als:

$$I_M T + I_{ref1}\tau + I_{ref2}\left(T - \tau\right) = 0$$

Die an Messwiderstand $R_M$, Referenzwiderstand $R_{ref}$, erstem Heizwiderstand $R_{MH}$ und zweitem Heizwiderstand $R_{refH}$ anfallende Verlustleistung lässt sich demnach beschreiben durch:

$$P = \frac{U_M^2}{R_M} + \frac{U_{ref2}^2}{R_{ref}}\left(1-\delta\right) + \frac{U_{ref1}^2}{R_{ref}}\delta$$

$$+ \frac{U_{ref2}^2}{R_{refH}}\delta + \frac{U_{ref1}^2}{R_{refH}}\left(1-\delta\right)$$

$$+ \frac{\left(-U_M - U_{ref2}\right)^2}{R_{MH}}\left(1-\delta\right) + \frac{\left(-U_M - U_{ref1}\right)^2}{R_{MH}}\delta$$

Mit

$$R_M = R_{ref} \quad ; \quad R_{MH} = R_M \quad ; \quad R_{refH} = \frac{1}{2} R_{MH}$$

Einsetzen der obigen Formel für den Messstrom IM und Umformung mittels Ohmschen Gesetzes lässt sämtliche Abhängigkeiten vom Tastgrad $\delta$ verschwinden, sodass auch hier die Gesamtverlustleistung messwertunabhängig ist. Allerdings liegt der (konstante) Gesamtbetrag der Verlustleistung höher als beim A/D-Wandler 10' der Figur 2, nämlich um die am zusätzlichen Heizwiderstand $R_{refH}$ anfallende Verlustleistung.

Selbstverständlich ist auch diese Ausführungsform, wie in Figur 3 gezeigt, durch einen zusätzlichen Integrator am Komparator-Referenzeingang 222 des Komparators 22 erweiterbar, um gleichspannungsabhängige Effekte am Kondensator 125 zu vermeiden. Zur Erläuterung wird auf das oben zu Figur 2 gesagte verwiesen.

Figur 4 zeigt schematisch den Spannungsverlauf über dem Kondensator 125 des Integrators 12, wie er bei den erfindungsgemäßen A/D-Wandlern gemäß den Figuren 2 und 3 auftritt. Während einer ersten Phase t1 eines Schalttaktes, während der der Referenzspannungsschalter 16 bzw. 16' die erste Referenzspannung $U_{ref1}$ kontaktiert, wird über dem Kondensator 125 eine sich aus der Summe von Messstrom $I_M$ und erstem Referenzstrom $I_{ref1}$ resultierende Spannung aufintegriert. Die Dauer dieser ersten Phase t1 ist von der Steuereinrichtung 40 vorgegeben und in jedem Messtakt gleich. Eine zweite Messtaktphase $\tau$ beginnt mit dem Umschalten des Referenzspannungsschalters 16 bzw. 16', sodass die Spannung über den Kondensator 125 gemäß der Summe der gleichgerichteten Ströme IM und $I_{ref2}$ abintegriert wird. Die zweite Messphase $\tau$ wird durch ein Signal des Komparators 22 beendet, welches ergeht, sobald die Komperatoreingangsspannung, d.h. die über dem Kondensator 125 anliegende Spannung gleich der Komparator-Referenzspannung ist. Die Gesamtdauer T des Messtaktes entspricht der Summe aus t1 + $\tau$. Die Komparator-Referenzspannung ist üblicherweise, z.B. auch bei dem A/D-Wandler gemäß Figur 1, gleich Null. Bei den Ausführungsformen gemäß den Figuren 2 und 3 ist die Komparator-Referenzspannung jedoch von Null verschieden. Insbesondere ist sie mittels des zusätzlichen Integrators 30 um den Mittelwert der im vergangenen Messtakt über den Kondensator 125 anliegenden Spannung versetzt, insbesondere aufgrund der invertierenden Wirkung des zusätzlichen Integrators 30 "nach unten" versetzt. Mit anderen Worten pendelt die Spannung über dem Kondensator 125 exakt um Null, was einer Wechselspannung ohne Gleichanteil entspricht. Gleichspannungsabhängige Kondensatoreffekte werden auf diese Weise vermieden.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum von Variationsmöglichkeiten an die Hand gegeben. Insbesondere sind die spezielle Dimensionierung der einzelnen Bauteile sowie die Wahl der zeitlichen Taktung vom Fachmann an die Erfordernisse des Einzelfalls anzupassen.

Bezugszeichenliste

| | |
|---|---|
| 10, 10', 10" | A/D-Wandler |
| 12 | Integrator |
| 121 | Operationsverstärker von 12 |
| 122 | invertierender Eingang von 121 |
| 123 | nicht-invertierender Eingang von 121 |
| 124 | Ausgang von 121 |
| 125 | Kondensator von 12 |
| 126 | Ausgang von 12 |
| 14 | Messspannungseingang |
| 16, 16' | Referenzspannungsschalter |
| 17 | zweiter Referenzspannungsschalter |
| 18 | erster Referenzspannungseingang |
| 20 | zweiter Referenzspannungseingang |
| 22 | Komparator |
| 221 | Testspannungseingang von 22 |
| 222 | Referenzspannungseingang von 22 |
| 223 | Ausgang von 22 |
| 24 | Inverter |
| 30 | zusätzlicher Integrator |
| 301 | Operationsverstärker von 30 |

| 302 | invertierender Eingang von 301 |
| 303 | nicht-invertierender Eingang von 301 |
| 304 | Ausgang von 301 |
| 305 | Kondensator von 30 |
| 32 | Eingangswiderstand vor 30 |

| $R_M$ | Messwiderstand |
| $R_{MH}$ | erster Heizwiderstand |
| $R_{ref}$ | Referenzwiderstand |
| $R_{refH}$ | zweiter Heizwiderstand |
| $U_M$ | Messspannung |
| IM | Messstrom |
| $U_{ref1}$ | erste Referenzspannung |
| $I_{ref1}$ | erster Referenzstrom |
| $U_{ref2}$ | zweite Referenzspannung |
| $I_{ref2}$ | zweiter Referenzstrom |
| T | Messtaktdauer |
| t1 | Dauer der Aufintegrationsphase |
| $\tau$ | Dauer der Abintegrationsphase |

**Patentansprüche**

1. Integrierender A/D-Wandler, umfassend

   - einen Messspannungseingang (14) zum Anlegen einer zu digitalisierenden, analogen Messspannung ($U_M$), der über einen Messwiderstand ($R_M$) mit dem invertierenden Eingang (122) eines Integrators (12) verbunden ist,
   - einen ersten Referenzspannungseingang (18) zum Anlegen einer ersten Referenzspannung ($U_{ref1}$) und einen zweiten Referenzspannungseingang (20) zum Anlegen einer zweiten Referenzspannung ($U_{ref2}$), wobei der erste und der zweite Referenzspannungseingang (18,20) mittels eines ersten Referenzspannungsschalters (16, 16') alternativ zueinander über einen ersten Referenzwiderstand ($R_{ref}$) mit dem invertierenden Eingang (122) des Integrators (12) verbindbar sind,
   - einen dem Integrator (12) nachgeschalteten Komparator (22) zum Vergleichen einer an seinem Komparator-Testspannungseingang (221) anliegenden Testspannung mit einer an seinem Komparator-Referenzspannungseingang (222) anliegenden Komparator-Referenzspannung, wobei der Komparator-Testspannungseingang (221) mit dem Ausgang (126) des Integrators (12) verbunden ist, und
   - eine Steuereinrichtung (40), die eingerichtet ist, den ersten Referenzspannungsschalter (16, 16') getaktet zu betätigen und Zeitintervalle zwischen einzelnen Schaltvorgängen zu messen,

   **dadurch gekennzeichnet,**
   **dass** zwischen dem Messspannungseingang (14) und dem Ausgang des ersten Referenzspannungsschalters (16, 16') ein die Messspannung ($U_M$) invertierender Inverter (24) und ein erster Heizwiderstand ($R_{MH}$), der thermisch mit dem Messwiderstand ($R_M$) gekoppelt ist, hintereinander geschaltet sind,
   wobei die an Mess-($R_M$), Heiz- ($R_{MH}$) und Referenzwiderstand ($R_{ref}$) anfallende Gesamtverlustleistung messwertunabhängig ist.

2. Integrierender A/D-Wandler nach Anspruch 1,
   **dadurch gekennzeichnet,**
   **dass** der Widerstandswert des Referenzwiderstandes ($R_{ref}$) gleich dem Widerstandswert des Messwiderstandes ($R_M$) ist.

3. Integrierender A/D-Wandler nach einem der vorangehenden Ansprüche,
   **dadurch gekennzeichnet,**
   **dass** ein dem ersten Referenzspannungsschalter (16') entgegengesetzt getakteter, zweiter Referenzspannungsschalter (17) vorhanden ist, mittels dessen der erste und der zweite Referenzspannungseingang (18,20) alternativ zueinander über einen zweiten Heizwiderstand ($R_{refH}$), der thermisch mit dem Referenzwiderstand ($R_{ref}$) und dem Messwiderstand ($R_M$) gekoppelt ist, mit Masse verbindbar sind.

**4.** Integrierender A/D-Wandler nach Anspruch 3,
**dadurch gekennzeichnet,**
**dass** der Widerstandswert des zweiten Heizwiderstandes ($R_{refH}$) halb so groß wie der Widerstandswert des ersten Heizwiderstandes ($R_{MH}$) ist.

## Claims

**1.** Integrating analog-to-digital converter, comprising:

- a measuring voltage input (14) for application of an analog measurement voltage ($U_M$) to be digitalised, the input being connected by way of a measuring resistor ($R_M$) with the inverting input (122) of an integrator (12),
- a first reference voltage input (18) for application of a first reference voltage ($U_{ref1}$) and a second reference voltage input ((20) for application of a second reference voltage ($U_{ref2}$), wherein the first and the second reference voltage inputs (18, 20) are connected - alternatively to one another - by means of a first reference voltage switch (16, 16') with the inverting input (122) of the integrator (12) by way of a first reference resistance ($R_{ref}$),
- a comparator (22), which is downstream of the integrator (12), for comparison of a test voltage, which is present at its comparator test voltage input (221), with a comparator reference voltage present at its comparator reference voltage input (222), wherein the comparator test voltage input (221) is connected with the output (126) of the integrator (12) and
- a control device (40) arranged to cyclically actuate the first reference voltage switch (16, 16') and to measure time intervals between individual switching processes,

**characterised in that**
an inverter (24) inverting the measurement voltage ($U_M$) and a first heating resistance ($R_{MH}$) thermally coupled with the measurement resistor ($R_M$) are connected in series between the measuring voltage input (14) and the output of the first reference voltage switch (16, 16'), wherein the total loss power arising at the measuring resistance ($R_M$), heating resistance ($R_{MH}$) and reference resistance ($R_{ref}$) is independent of the measurement value.

**2.** Integrating analog-to-digital converter according to claim 1, **characterised in that** the resistance value of the reference resistance ($R_{ref}$) is the same as the resistance value of the measuring resistance ($R_M$).

**3.** Integrating analog-to-digital converter according to one of the preceding claims, **characterised in that** a second reference voltage switch (17) cycled oppositely to the first reference voltage switch (16') is present, the first and second reference voltage inputs (18, 20) being connectible by means of the second reference voltage switch (18, 20) with ground alternatively to one another via a second heating resistance ($R_{refH}$) thermally coupled with the reference resistance ($R_{ref}$) and the measuring resistance ($R_M$).

**4.** Integrating analog-to-digital converter according to claim 3, **characterised in that** the resistance value of the second heating resistance ($R_{refH}$) is half the size of the resistance value of the first heating resistance ($R_{MH}$).

## Revendications

**1.** Convertisseur A/N à intégration, comprenant

- une entrée de tension de mesure (14) pour l'application d'une tension de mesure ($U_M$) analogique à numériser, laquelle est reliée par une résistance de mesure ($R_M$) à l'entrée à inversion (122) d'un intégrateur (12),
- une première entrée de tension de référence (18) pour l'application d'une première tension de référence ($U_{ref1}$) et une deuxième entrée de tension de référence (20) pour l'application d'une deuxième tension de référence ($U_{ref2}$), dans lequel la première et la deuxième entrées de tension de référence (18, 20) peuvent être reliées en alternance à l'entrée à inversion (122) de l'intégrateur (12), au moyen d'un premier commutateur de tension de référence (16, 16') et par une première résistance de référence ($R_{ref}$),
- un comparateur (22) situé en aval de l'intégrateur (12) pour la comparaison d'une tension d'essai appliquée à son entrée de tension d'essai (221) de comparateur avec une tension de référence de comparateur appliquée à son entrée de tension de référence (222) de comparateur, dans lequel l'entrée de tension d'essai (221) de comparateur est reliée à la sortie (126) de l'intégrateur (12), et
- un dispositif de commande (40) prévu pour actionner de manière cyclique le premier commutateur de tension de référence (16, 16') et pour mesurer des intervalles temporels entre les différentes commutations,

**caractérisé**
**en ce qu'**un circuit inverseur (24) inversant la tension de mesure ($U_M$) et une première résistance chauffante ($R_{MH}$) couplée thermiquement à la résistance de mesure ($R_M$) sont montées l'un derrière l'autre entre l'entrée de tension de mesure (14) et la sortie du premier commutateur de tension de référence (16, 16'),
dans lequel une perte de puissance totale sur la résistance de mesure ($R_M$), la résistance chauffante ($R_{MH}$) et la résistance de référence ($R_{ref}$) est indépendante de la valeur de mesure.

2. Convertisseur A/N à intégration selon la revendication 1,
**caractérisé**
**en ce que** la valeur de résistance de la résistance de référence ($R_{ref}$) est égale à la valeur de résistance de la résistance de mesure ($R_M$).

3. Convertisseur A/N à intégration selon l'une des revendications précédentes,
**caractérisé**
**en ce qu'**un deuxième commutateur de tension de référence (17) cadencé inversement au premier commutateur de tension de référence (16') est présent, au moyen duquel la première et la deuxième entrées de tension de référence (18, 20) peuvent être reliées en alternance à la masse par une deuxième résistance chauffante ($R_{refH}$) couplée thermiquement à la résistance de référence ($R_{ref}$) et à la résistance de mesure ($R_M$).

4. Convertisseur A/N à intégration selon la revendication 3,
**caractérisé**
**en ce que** la valeur de résistance de la deuxième résistance chauffante ($R_{refH}$) est égale à la moitié de la valeur de résistance de la première résistance chauffante ($R_{MH}$).

**Fig. 1** Stand der Technik

**Fig. 2**

**Fig. 3**

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 02103914 A2
- US 4951053 A
- DE 2821146 B2
- US 4270119 A
- GB 2120481 A